# EUROPÄISCHE PATENTSCHRIFT

(11) **EP 1 390 951 B1**
(45) Veröffentlichungstag und Bekanntmachung des Hinweises auf die Patenterteilung: **16.03.2005**
(21) Anmeldenummer: 02740591.9
(22) Anmeldetag: 13.05.2002
(51) Int. Cl.: G11C 29/00

(54) **DYNAMISCHER SPEICHER UND VERFAHREN ZUM TESTEN EINES DYNAMISCHEN SPEICHERS**
DYNAMIC MEMORY AND METHOD FOR TESTING A DYNAMIC MEMORY
MEMOIRE DYNAMIQUE ET METHODE DE TEST D'UNE MEMOIRE DYNAMIQUE

(30) Priorität: 22.05.2001 DE 10125022
(43) Veröffentlichungstag der Anmeldung: 25.02.2004
(73) Patentinhaber: Infineon Technologies AG, 81669 München (DE)
(72) Erfinder: OHLHOFF, Carsten, 80798 München (DE)
(74) Vertreter: Ginzel, Christian
(86) Internationale Anmeldenummer: PCT/EP2002/005244
(87) Internationale Veröffentlichungsnummer: WO 2002/095756

(56) Entgegenhaltungen:
- DE-A- 19 904 054
- US-A- 5 995 424
- US-A- 6 141 280

## Beschreibung

Die Erfindung betrifft einen dynamischen Speicher nach dem Oberbegriff vom Patentanspruch 1 und ein Verfahren zum Testen eines dynamischen Speichers nach dem Oberbegriff von Patentanspruch 8.

In der Regel werden integrierte Schaltungen beziehungsweise Chips bereits auf Waferebene, also vor dem Gehäusen getestet. Ein derartiger Test ist bei Halbleiterspeichern, insbesondere bei dynamischen Speichern beziehungsweise DRAMs (Dynamic Random Access Memories) besonders wichtig, da einzelne Ausfälle von Speicherzellen den gesamten Speicher unbrauchbar machen. Mit zunehmender Speicherkapazität insbesondere der dynamischen Speicher steigen die Testzeiten stark an und verursachen mittlerweile einen beträchtlichen Anteil an den gesamten Produktionskosten. Da bei derartigen im hohen Volumen gefertigten Standardprodukten die Produktionskosten ein bedeutender wirtschaftlicher Faktor sind, werden große Anstrengungen unternommen, um diese zu senken.

Ein Ansatzpunkt besteht in der Verringerung der Testzeiten von dynamischen Speichern. Ein anderer Ansatzpunkt besteht darin, mehrere Speicher parallel zu testen. Hierdurch werden die teuren Produktionstester besser ausgelastet. Ferner wird der Durchsatz beim Testen erhöht.

Ein dritter Ansatz schlägt eine etwas andere Richtung ein: Auf einem dynamischen Speicher wird eine spezielle Logik zum Testen integriert, welche die externen Tests unterstützt oder gar ganz ersetzt. Dies ist bereits aus dem Gebiet der logischen Schaltkreise bekannt. Dort werden beispielsweise auf komplexen Mikroprozessoren sogenannte BIST (Bild In Self Test)-Module integriert, die zum (Selbst-)Testen des Mikroprozessors dienen. Hierzu arbeiten die BIST-Module Testprogramme zum Testen einzelner Module des Prozessors ab. Überwiegend werden funktionale Testprogramme eingesetzt. Die BIST-Module erzeugen die entsprechenden Testmuster. Ein externer Test ist dadurch kürzer oder kann manchmal ganz entfallen. Insbesondere die Anzahl der von einem externen Tester zur Verfügung gestellten Signale reduziert sich dadurch erheblich. Zudem kann ein derartiges Bauelement auch im Betrieb ohne externen Testautomaten getestet werden. Ein solcher dynamischer Speicher ist beispielsweise in der US-A 5,883,843 offenbart.
Für einen vollständigen Selbsttest muss ein Testkontroller beziehungsweise ein BIST-Modul Zeitabläufe (Timings) steuern können. Dies bereitet in der Regel für Funktionaltests keine Probleme, da die dafür notwendigen Frequenzen typischerweise im MHz-Bereich liegen. Als Zeitbasis nutzt ein Chip mit einem derartigen integrierten Testkontroller einen an den Chip angelegten externen Oszillatortakt.
Probleme bereitet dieses Verfahren jedoch bei dynamischen Speichern. Diese benötigen nämlich für einen vollständigen Selbsttest zum Teil recht langsame Oszillatortakte. Bisher wurden derartige Takte von speziellen Oszillatoren zur Verfügung gestellt, die in den Produktionstestern vorhanden sind und die unabhängig und asynchron von der zeitlichen Steuerung der eigentlichen Testpattern programmiert werden können. Gerade diese langsamen Zeitbasen dominieren jedoch die Testzeit. Dadurch wird ein Produktionstester länger benötigt. Der Testdurchsatz verringert sich entsprechend.

Als Beispiel für einen Testablauf eines dynamischen Speichers, der eine besonders langsame Zeitbasis benötigt, sei hier das periodische Auffrischen der Speicherzellen (Refresh) in funktionalen Tests erwähnt. Weitere Beispiele sind die Messung der Halte- oder Retention-Zeit von einzelnen Speicherzellen oder der sogenannte Bump-Test. Jeder dieser Tests benötigt eine langsame Zeitbasis im Mikro- oder gar Millisekunden-Zeitbereich.

Aufgabe der vorliegenden Erfindung ist es daher, einen dynamischen Speicher und ein Verfahren zum Testen eines dynamischen Speichers vorzuschlagen, welche es ermöglichen, auch lang andauernde Testabläufe durch einen im dynamischen Speicher integrierten Testkontroller durchführen zu können.

Diese Aufgabe wird durch einen dynamischen Speicher mit den Merkmalen nach Patentanspruch 1 und durch ein Verfahren zum Testen eines dynamischen Speichers mit den Merkmalen nach Patentanspruch 8 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Der Erfindung liegt die Erkenntnis zugrunde, dass sich ein Oszillator, den zumindest einige dynamische Speicher aufweisen und der im Standard-Betrieb des Speichers das Auffrischen des Speicherzellenfeldes steuert, als Zeitbasis für einen auf dem dynamischen Speicher enthaltenen Testkontroller eignet, da Auffrisch-Vorgänge periodisch in Zeitabständen von einigen Mikro-, Milli- oder gar Sekunden auftreten. Durch die im Verhältnis zu funktionalen Tests von Logik "langsame" Zeitbasis des Oszillators kann der Testkontroller dadurch Testabläufe steuern, die bisher aufgrund eines auf dem dynamischen Speicher nicht vorhandenen "langsamen" Taktes nur durch Produktionstester durchgeführt werden konnten.

Vorrichtungsgemäß weist ein dynamischer Speicher mit einem Speicherzellenfeld, einem Testkontroller zum Testen des Speicherzellenfeldes und einem Oszillator zum Steuern eines Auffrischens des Speicherzellenfelds Mittel zum Nutzen des Oszillators als Zeitbasis für den Testkontroller auf.

Die Mittel können einen Zähler umfassen, der Takte im Ausgangssignal des Oszillators zählt und nach einer vorbestimmten Taktanzahl mindestens einen Interrupt an den Testkontroller sendet. Damit steht dem Testkontroller über den Interrupt ein Signal zur Verfügung, das in relativ großen Zeitabständen, insbesondere von Mikro- oder gar Millisekunden, auftritt.

Die vorbestimmte Taktanzahl ist vorzugsweise in einem programmierbaren Register gespeichert. Dies ermöglicht über eine Umprogrammierung eine Änderung der Zeitbasis für den Testkontroller. Im Prinzip sind dadurch je nach Abhängigkeit des gewünschten Testablaufs verschiedene Zeitbasen einstellbar. Alternativ kann die Frequenz des Oszillators durch ein programmierbares Register eingestellt werden. Im wesentlichen läuft dies auf dasselbe hinaus, nämlich eine Änderung der Zeitbasis. Die Vorteile bleiben daher im wesentlichen gleich.

Der Zähler kann nun derart ausgebildet sein, das genau ein Interrupt erzeugt wird. In diesem Fall wird der Oszillator sozusagen als Trigger genutzt. Zu einem bestimmten Zeitpunkt stößt der Testkontroller vorzugsweise ein Zählen der im Ausgangssignal des Oszillators enthaltenen Takte an, beispielsweise um die Haltezeit von Speicherzellen des Speicherzellenfeldes zu messen. Sobald ein Interrupt eintrifft, der vom Zähler erzeugt wird, detektiert der Testkontroller, dass die Haltezeit abgelaufen ist und kann den Inhalt der Speicherzellen des Speicherzellenfeldes messen.

Alternativ hierzu kann der Zähler auch periodisch Interrupts erzeugen, vorzugsweise immer dann, wenn der Zählerstand einem ganzzahligen Vielfachen der vorbestimmten Taktanzahl entspricht. Diese Ausführungsform eignet sich insbesondere zum periodischen Testen, beispielsweise wenn mehrmals hintereinander die Haltezeit bestimmter Speicherzellen des Speicherzellenfeldes gemessen werden sollen.

In einer bevorzugten Ausführungsform ist der Testkontroller derart ausgebildet, dass er beim Eintreffen eines Interrupts einen Auffrischvorgang des Speicherzellenfeldes durchführt (Refresh-Modus) oder ein unterbrochenes Testprogramm (Spannungsmess-Modus) fortsetzt. Während eines unterbrochenen Testprogrammes können beispielsweise interne Spannungen verändert werden. Anschließend kann im Rahmen des fortgesetzten Testprogramms der Inhalt der Speicherzellen gemessen werden. Dadurch ist die Spannungsabhängigkeit der Speicherzellen und sonstigen Schaltungselemente des dynamischen Speichers testbar.

Das erfindungsgemäße Verfahren zum Testen eines dynamischen Speichers, der ein Speicherzellenfeld, einen Testkontroller zum Testen des Speicherzellenfeldes und einen Oszillator zum Steuern eines Auffrischen des Speicherzellenfeldes umfaßt, zeichnet sich dadurch aus, dass aus dem Ausgangssignal des Oszillators mindestens ein Signal zum Steuern eines Testvorganges des Speicherzellenfeldes durch den Testkontroller erzeugt wird.

Vorzugsweise werden Takte im Ausgangssignal des Oszillators gezählt; nach einer vorbestimmten Taktanzahl wird dann mindestens ein Interrupt erzeugt und an den Testkontroller gesendet. Hierdurch ist der dynamische Speicher nicht mehr auf externe Interrupts, die beispielsweise von einem Produktionstester erzeugt werden, angewiesen. Damit können "langsame", d.h. zeitlich lang andauernde Tests vom Speicher selbst durchgeführt werden. Weitere Vorteile bestehen darin, daß der externe Produktionstester nicht über einen Timer verfügen muß bzw. die Anzahl der Pins des dynamischen Speichers, die für den Test kontaktiert werden müssen, verringert werden, da kein spezieller Pin zum Zuführen externer Interrupts zu Testzwecken vorgesehen sein muß. Ein externer Produktionstester wird nicht mehr so lange belegt, wodurch der Durchsatz an zu testenden Speichern erhöht werden kann.

Die vorbestimmte Taktanzahl kann in Abhängigkeit des durchzuführenden Testablaufs eingestellt werden. Dies ist insbesondere dann vorteilhaft, wenn der Speicher eine möglichst große Bandbreite verschiedener Tests, insbesondere Tests mit verschiedenen Zeitbasen, durchführen soll. Als Beispiel seien hier nur der Auffrisch- oder Spannungsabhängigkeits-Test genannt, der eine sehr "langsame" Zeitbasis erfordert. Im Gegensatz hierzu benötigen funktionale Tests von auf dem Speicher enthaltener Logik in der Regel "schnelle" Zeitbasen. Eine Umschaltung der Zeitbasis kann durch die Einstellung der vorbestimmten Taktanzahl sehr einfach vorgenommen werden.

Vorzugsweise bewirkt ein Interrupt, dass erneut Takte am Ausgangssignal des Oszillators gezählt werden und bei Erreichen der vorbestimmten Taktanzahl ein weiterer Interrupt erzeugt wird. Dies führt zu einer periodischen Erzeugung von Interrupts mit einer Periode entsprechend der durch die vorbestimmten Taktanzahl vorgegebenen Zeitdauer. Beispielsweise kann dies vorteilhaft zum mehrmaligen wiederholen bestimmter Patternsequenzen eines Tests eingesetzt werden.

Schließlich bewirkt in einer bevorzugten Ausführungsform ein Interrupt im Testkontroller, dass ein Auffrischen des Speicherzellenfelds gestartet oder ein unterbrochenes Testprogramm fortgesetzt wird. Im ersten Fall dient der Interrupt sozusagen als Auffrisch-Takt, in zweiten Fall dient er zum Beenden der Unterbrechung eines Testprogramms, während dem beispielsweise die Spannungsabhängigkeit bestimmter Module des Speichers gemessen wurde.

Der Testkontroller kann auch nach Eintreffen eines ersten Interrupts ein laufendes Testprogramm unterbrechen und sodann einen Retention- oder Bump-Test starten. Während dieser Tests werden vorzugsweise interne elektrische Spannungen am Speicherzellenfeld verändert. Nach Eintreffen eines zweiten Interrupts kann der Testkontroller das unterbrochene Testprogramm fortsetzen. Dieses kann dann beispielsweise das Speicherzellenfeld auslesen und feststellen, welche Speicherzellen aufgrund der Veränderungen der elektrischen Spannungen ihre gespeicherten Daten verloren haben.

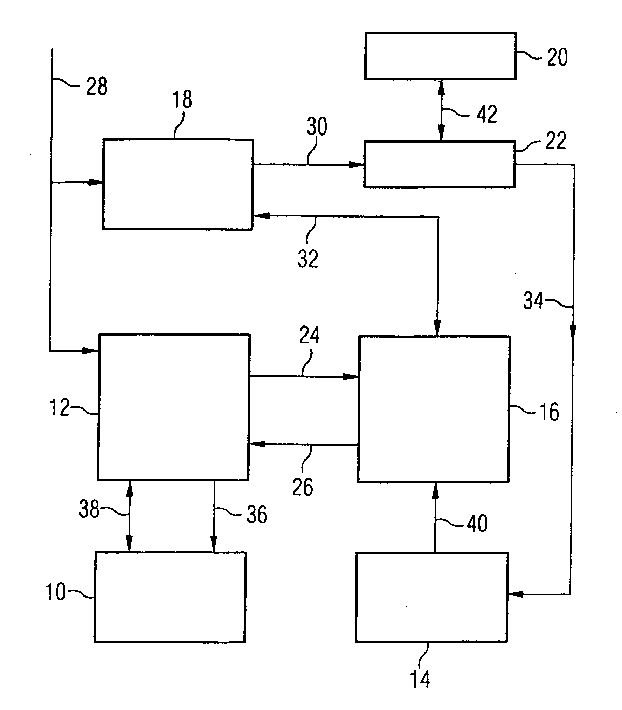

Nachfolgend wird nun ein Ausführungsbeispiel der Erfindung anhand der Zeichnung erläutert. Diese zeigt in der einzigen
- Fig. 1: ein Blockschaltbild eines dynamischen Speichers, in dem der Oszillator zum Steuern eines Auffrischens des Speicherzellenfeldes zu Testzwecken im Sinne der Erfindung herangezogen wird.

Der dargestellte dynamische Speicher weist ein Speicherzellenfeld 10 auf. Ferner sind ein BIST-Testkontroller 12 zur Ausführung von Selbsttests, ein Oszillator 14 zum Steuern des Auffrischens des Speicherzellenfeldes 10, ein programmierbarer Zähler 16, programmierbare Register 18, eine Fusebank 20 und Fuse-Latches 22 vorgesehen.

In der Regel wird der Oszillator 14, genauer gesagt dessen Oszillationsfrequenz während eines Produktionstest des dynamischen Speichers für den späteren Normal-Betrieb auf eine bestimmte Zielfrequenz eingestellt, sozusagen kalibriert. Dies erfolgt mittels der Fusebank 20 und den Fuse-Latches 22. Hierzu wird eine gegebenenfalls erforderliche, während eines Speichertests festgestellte Korrektur der Oszillationsfrequenz des Oszillators 14 als binärer Wert während des Produktionstests in der Fusebank 20 gespeichert. Diese besteht vorzugsweise aus elektrisch programmierbaren Fuses, die teilweise während dem Speichertest entsprechend der gewünschten Korrektur mittels hoher Stromstärken "durchgebrannt" werden. Es können jedoch auch sogenannte "Laserfuses" verwendet werden, wie dies heute mehrheitlich in der Industrie der Fall ist. Die elektrischen Fuses haben den Vorteil, daß der BIST das Trimming selbst übernehmen und das Ergebnis sofort selbst auf dem Chip speichern kann.

Im Normalbetrieb wird die Fusebank 20 über den bidirektionale Fuse-Bus 42, der auch zum Beschreiben der Fusebank 20 dient, ausgelesen; der ausgelesene Inhalt wird in den Fuse-Latches 22 gespeichert. Diese werden wiederum über den unidirektionalen Frequenzkorrektur-Bus 34 vom Oszillator 14 ausgelesen. Der Oszillator 14 stellt daraufhin seine Oszillationsfrequenz auf den in der Fusebank 20 gespeicherten Korrekturwert entsprechend ein.

Der (programmierbare) Testkontroller 12 dient zur Durchführung von Selbsttests des dynamischen Speichers. Diese können sowohl während eines Produktionstests des Speichers als auch im späteren Normal-Betrieb durchgeführt werden. Die Programmierung des Testkontrollers 12 kann beispielsweise aus einem (nicht dargestellten) Festwertspeicher (ROM: Read Only Memory) erfolgen, der ebenfalls auf dem dynamischen Speicher als eigenes Modul integriert oder aber auch extern vorgesehen sein kann. Im Falle eines externen Festwertspeichers, der Selbsttest-Programme für den dynamischen Speicher enthält, greift der Testkontroller 12 über den Testprogramm-Bus 28 auf den Festwertspeicher zu. Ebenso kann der Testkontroller 12 über eine geeignete Programmierschnittstelle gemäß dem Standard IEEE Std. 1149.1 programmiert werden.

Während eines Selbsttests erzeugt der Testkontroller 12 Steuersignale auf dem Speicher-Steuerbus 36 zum Ansteuern des Speicherzellenfeldes 10 und schreibt oder liest Daten in bzw. aus das bzw. dem Speicherzellenfeld 10 über den bidirektionalen Speicher-Datenbus 38. Ein typischer Testprogrammablauf beginnt beispielsweise mit dem Beschreiben des Speicherzellenfeldes 10 mit Testdaten, beispielsweise dem Pattern "10101010...". Nach dem vollständigen Beschreiben des Speicherzellenfeldes 10 liest der Testkontroller die geschriebenen Testdaten wieder aus und prüft, ob die ausgelesenen Werte mit den vorher eingeschriebenen Werte übereinstimmen. Im Falle einer Nichtübereinstimmung gibt der Testkontroller ein Signal aus, das einen Ausfall des dynamischen Speichers signalisiert. Dies sind sogenannte Funktionaltests des Speichers, da lediglich die Funktion der auf dem Speicher enthaltenen Komponenten getestet wird.

Zum Durchführen länger andauernder Tests benötigt der Testkontroller 12 eine "langsame" Zeitbasis. Diese steht ihm in Form des Oszillators 14, der eigentlich zum Steuern des Auffrischens des Zellenfeldes 10 gedacht ist, zur Verfügung. Das Ausgangssignal 40 des Oszillators 14 ist ein Taktsignal mit der Oszillationsfrequenz. Der Zähler 16 dient zum Zählen der Takte im Ausgangssignal 40. Er ist allerdings erst im Betrieb, wenn der Testkontroller 12 mittels eines Startsignals 24 den Zähler 16 freigibt. Nach Freigabe beginnt der Zähler 16 mit dem Zählen der Takte im Ausgangssignal 40 und erzeugt einen Interrupt 26, wenn der Zählwert eine vorbestimmte Taktanzahl erreicht, d.h. der Zählwert genau der vorbestimmten Taktanzahl entspricht. Mit dem Interrupt 26 steht dem Testkontroller 12 eine Zeitbasis zur Verfügung, die über eine entsprechende Programmierung des Zählers 16 auf sehr große Werte einstellbar ist.

Die Programmierung erfolgt über die programmierbaren Register 18, in die über den Testprogramm-Bus 28 die vorbestimmte Taktanzahl einstellbar ist. Über den Bus 32 kann der Zähler 16 die programmierbaren Register 18 auslesen. Alternativ können über die programmierbaren Register 18 auch die Fuse-Latches 22 über den Bus 30 umprogrammiert werden. Dies bewirkt eine Änderung der Oszillationsfrequenz des Oszillators 14.

Somit läßt sich also die Zeitbasis, die von dem Oszillator 14 abgeleitet ist auf zwei verschiedene Arten ändern: einerseits über eine Programmierung des Zählers 16 und andererseits über die Umprogrammierung der Oszillationsfrequenz des Oszillators 14 über die Fuse-Latches 22.

Das Interruptsignal 26 des Zählers 16 kann vom Testkontroller unterschiedlich ausgewertet werden: beispielsweise kann der Testkontroller eine laufende Routine eines Testprogramms stoppen und in eine andere Programmroutine springen, um dort durch den Interrupt 26 getriggert ein bestimmtes Test-Unterprogramm zu starten. Dieses Test-Unterprogramm kann beispielsweise ein Auffrischen des Speicherzellenfeldes 10 bewirken oder einen Test der Spannungsabhängigkeit des Speicherzellenfeldes 10 einleiten. In diesem Fall werden die Versorgungsspannungen des Speicherzellenfeldes erhöht oder verringert bis ein weiterer Interrupt 26 des Zählers 16 die Veränderung des Versorgungsspannungen stoppt und den Speicher normal weiter testet. Durch einen Interrupt 26 kann auch ein vorher unterbrochenes Testprogramm fortgesetzt werden. Insbesondere zwischen zwei zeitlich aufeinander folgenden Interrupts 26 können die erwähnten Retention- und Bump-Tests durchgeführt werden.

### Bezugszeichenliste

- 10: Speicherzellenfeld
- 12: Testkontroller
- 14: Oszillator
- 16: (programmierbarer) Zähler
- 18: (programmierbare) Register
- 20: Fusebank
- 22: Fuse-Latches
- 24: Startsignal
- 26: Interrupt(signal)
- 28: Testprogramm-Bus
- 30: Bus
- 32: Bus
- 34: unidirektionaler Frequenzkorrektur-Bus
- 36: Speicher-Steuerbus
- 38: Speicher-Datenbus
- 40: (Oszillator-)Ausgangssignal
- 42: bidirektionaler Fuse-Bus

## Patentansprüche

1. Dynamischer Speicher mit einem Speicherzellenfeld (10), einem Oszillator (14) zum Steuern eines Auffrischen des Speicherzellenfeldes (10), einem Testkontroller (12) zur Ausführung von Selbsttests des Speicherzellenfelds (10) und Mittel (16) zum Nutzen des Oszillators (14) als Zeitbasis für den Testkontroller (12),
**dadurch gekennzeichnet, daß** die Zeitbasis für den Selbsttest langsam im Vergleich zu einer Zeitbasis für einen funktionalen Test des Speicherzellenfelds (10) ist.

2. Dynamischer Speicher nach Anspruch 1,
**dadurch gekennzeichnet, daß** die Mittel einen Zähler (16) umfassen, der Takte im Ausgangssignal des Oszillators (14) zählt und nach einer vorbestimmten Taktanzahl mindestens einen Interrupt (26) an den Testkontroller (12) sendet.

3. Dynamischer Speicher nach Anspruch 2,
**dadurch gekennzeichnet, daß** die vorbestimmte Taktanzahl in einem programmierbaren Register (18) gespeichert ist.

4. Dynamischer Speicher nach Anspruch 2,
**dadurch gekennzeichnet, daß** die Frequenz des Oszillators (14) durch ein programmierbares Register (18,22) einstellbar ist.

5. Dynamischer Speicher nach einem der Ansprüche 2 bis 4,
**dadurch gekennzeichnet, daß** der Zähler (16) derart ausgebildet ist, dass genau ein Interrupt (26) erzeugt wird.

6. Dynamischer Speicher nach einem der Ansprüche 2 bis 4,
**dadurch gekennzeichnet, daß** dass der Zähler (16) derart ausgebildet ist, dass jedes mal ein Interrupt (26) erzeugt wird, wenn der Zählstand des Zählers ein ganzzahliges Vielfaches der vorbestimmten Taktanzahl erreicht.

7. Dynamischer Speicher nach einem der Ansprüche 2 bis 6,
**dadurch gekennzeichnet, daß** der Testkontroller (12) derart ausgebildet ist, dass er beim Eintreffen eines Interrupts (26) einen Auffrischvorgang des Speicherzellenfeldes (10) durchführt oder eine unterbrochenes Testprogramm fortsetzt.

8. Verfahren zum Testen eines dynamischen Speichers, der ein Speicherzellenfeld (10), einen Oszillator (14) zum Steuern eines Auffrischens des Speicherzellenfeldes (10) und einen Testkontroller (12) zur Ausführung von Selbsttests des Speicherzellenfeldes (10) umfaßt, wobei aus dem Ausgangssignal (40) des Oszillators (14) mindestens ein Signal (26) zum Steuern eines Selbsttestvorganges des Speicherzellenfeldes (10) durch den Testkontroller (12) erzeugt wird, **dadurch gekennzeichnet, daß** die vom Oszillator (14) bereitgestellte Zeitbasis für den Selbsttest langsam im Vergleich zu einer Zeitbasis für einen funktionalen Test des Speicherzellenfelds (10) ist.

9. Verfahren nach Anspruch 8,
**dadurch gekennzeichnet, daß** Takte im Ausgangssignal (40) des Oszillators (14) gezählt werden und nach einer vorbestimmten Taktanzahl mindestens ein Interrupt (26) erzeugt und an den Testkontroller (12) gesendet wird.

10. Verfahren nach Anspruch 9,
**dadurch gekennzeichnet, daß** die vorbestimmte Taktanzahl in Abhängigkeit des durchzuführenden Testablaufs eingestellt wird.

11. Verfahren nach Anspruch 9 oder 10,
**dadurch gekennzeichnet, daß** ein Interrupt bewirkt, dass erneut Takte im Ausgangssignal (40) des Oszillators (14) gezählt werden und bei Erreichen der vorbestimmten Taktanzahl ein weiterer Interrupt (26) erzeugt wird.

12. Verfahren nach einem der Ansprüche 8 bis 10,
**dadurch gekennzeichnet, daß** ein Interrupt (26) im Testkontroller (12) bewirkt, dass ein Auffrischen des Speicherzellenfeldes (10) gestartet oder ein unterbrochenes Testprogramm fortgesetzt wird.

13. Verfahren nach einem der Ansprüche 8 bis 11,
**dadurch gekennzeichnet, daß** nach Eintreffen eines ersten Interrupts (26) der Testkontroller (12) ein laufendes Testprogramm unterbricht und einen Retention- oder Bump-Test startet und nach Eintreffen eines zweiten Interrupts (26) das unterbrochene Testprogramm fortsetzt.

## Claims

1. Dynamic memory having a memory cell array (10), an oscillator (14) for controlling a refresh of the memory cell array (10), a test controller (12) for carrying out self-tests of the memory cell array (10) and means (16) for utilizing the oscillator (14) as time base for the test controller (12),
**characterized in that** the time base for the self-test is slow compared with a time base for a fuctional test of the memory cell array (10).

2. Dynamic memory according to claim 1,
**characterized in that**
the means comprise a counter (16), which counts clock cycles in the output signal of the oscillator (14) and, after a predetermined number of clock cycles, transmits at least one interrupt (26) to the test controller (12).

3. Dynamic memory according to Claim 2,
**characterized in that**
the predetermined number of clock cycles is stored in a programmable register (18).

4. Dynamic memory according to Claim 2,
**characterized in that**
the frequency of the oscillator (14) can be set by a programmable register (18, 22).

5. Dynamic memory according to one of claims 2 to.4,
**characterized in that**
the counter (16) is designed in such a way that precisely one interrupt (26) is generated.

6. Dynamic memory according to one of Claims 2 to 4,
**characterized in that**
the counter (16) is designed in such a way that an interrupt (26) is generated whenever the counter reading of the counter reaches an integer multiple of the predetermined number of clock cycles.

7. Dynamic memory according to one of Claims 2 to 6,
**characterized in that**
the test controller (12) is designed in such a way that, when an interrupt (26) arrives, it carries out a refresh operation of the memory cell array (10) or continues an interrupted test program.

8. Method for testing a dynamic memory which comprises a memory cell array (10), an oscillator (14) for controlling a refresh of the memory cell array (10) and a test controller (12) for carrying out self-tests of the memory cell array (10), at least one signal (26) for controlling a self-test operation of the memory cell array (10) by the test controller (12) being generated from the output signal (40) of the oscillator (14), **characterized in that** the time base, provided by the oscillator (14), for the self-test is slow compared with a time base for a functional test of the memory cell array (10).

9. Method according to Claim 8,
**characterized in that**
clock cycles are counted in the output signal (40) of the oscillator (14) and, after a predetermined number of clock cycles, at least one interrupt (26) is generated and transmitted to the test controller (12).

10. Method according to Claim 9,
**characterized in that**
the predetermined number of clock cycles is set in a manner dependent on the test sequence to be carried out.

11. Method according to Claim 9 or 10,
**characterized in that**
an interrupt has the effect that clock cycles are again counted in the output signal (40) of the oscillator (14) and a further interrupt (26) is generated when the predetermined number of clock cycles is reached.

12. Method according to one of Claims 8 to 10,
**characterized in that**
an interrupt (26) in the test controller (12) has the effect that a refresh of the memory cell array (10) is started or an interrupted test program is continued.

13. Method according to one of Claims 8 to 11,
**characterized in that**
after the arrival of a first interrupt (26), the test controller (12) interrupts a test program that is running and starts a retention or bump test and, after the arrival of a second interrupt (26) continues the interrupted test program.

## Revendications

1. Mémoire dynamique comprenant un champ (10) de cellules de mémoire, un oscillateur (14) pour commander un rafraîchissement du champ (10) de cellules de mémoire, un contrôleur (12) de test pour réaliser des autotests du champ (10) de cellules de mémoire, et des moyens (16) pour utiliser l'oscillateur (14) en base de temps pour le contrôleur (12) de test,
**caractérisée en ce que** la base de temps pour l'autotest est plus lente qu'une base de temps pour un test fonctionnel du champ (10) de cellules de mémoire.

2. Mémoire dynamique suivant la revendication 1,
**caractérisée en ce que** les moyens comprennent un compteur (16) qui compte les cadences dans le signal de sortie de l'oscillateur (14) et qui après un nombre de cadences déterminé à l'avance, envoie au moins un signal (26) d'interruption au contrôleur (12) de test.

3. Mémoire dynamique suivant la revendication 2,
**caractérisée en ce que** le nombre de cadences déterminé à l'avance est mémorisé dans un registre (18) pouvant être programmé.

4. Mémoire dynamique suivant la revendication 2, **caractérisée en ce que** la fréquence de l'oscillateur (14) peut être réglé par un registre (18, 22) pouvant être programmé.

5. Mémoire dynamique suivant l'une des revendications 2 à 4,
**caractérisé en ce que** le compteur (16) est conçu de façon à produire exactement un signal (26) d'interruption.

6. Mémoire dynamique suivant l'une des revendications 2 à 4,
**caractérisé en ce que** le compteur (16) est conçu de manière à produire un signal (26) d'interruption chaque fois que l'état du compteur atteint un multiple entier du nombre de cadences déterminé à l'avance.

7. Mémoire dynamique suivant l'une des revendications 2 à 6,
**caractérisée en ce que** le contrôleur (12) de test est conçu de manière à effectuer lors de l'arrivée d'un signal (26) d'interruption, une opération de rafraîchissement du champ (10) de cellules de mémoire ou à poursuivre un programme de test interrompu.

8. Procédé de test d'une mémoire dynamique qui comprend un champ (10) de cellules de mémoire, un oscillateur (14) pour commander un rafraîchissement du champ (10) de cellules de mémoire et un contrôleur (12) de test pour réaliser des autotests du champ (10) de cellules de mémoire, dans lequel on produit à partir du signal (40) de sortie de l'oscillateur (14) au moins un signal (26) de commande d'une opération d'autotest du champ (10) de cellules de mémoire par le contrôleur (12) de test,
**caractérisé en ce que** la base de temps mise à disposition par l'oscillateur (14) pour l'autotest est plus lente qu'une base de temps pour un test fonctionnel du champ (10) de cellules de mémoire.

9. Procédé suivant la revendication 8,
**caractérisé en ce que** l'on compte des cadences dans le signal (40) de sortie de l'oscillateur (14) et après un nombre de cadences déterminé à l'avance, on produit au moins un signal (26) d'interruption et on l'envoie au contrôleur (12) de test.

10. Procédé suivant la revendication 9,
**caractérisé en ce que** l'on règle le nombre de cadences déterminé à l'avance en fonction du déroulement du test à effectuer.

11. Procédé suivant la revendication 9 ou 10,
**caractérisé en ce qu'**un signal d'interruption fait que l'on compte à nouveau des cadences dans le signal (40) de sortie de l'oscillateur (14) et que l'on produit un autre signal (26) d'interruption lorsque le nombre de cadences déterminé à l'avance est atteint.

12. Procédé suivant l'une des revendications 8 à 10,
**caractérisé en ce que** un signal (26) d'interruption dans le contrôleur (12) de test fait que l'on fait débuter un rafraîchissement du champ (10) de cellules de mémoire ou que l'on poursuit un programme de test interrompu.

13. Procédé suivant l'une des revendications 8 à 11,
**caractérisé en ce qu'**après l'arrivée d'un premier signal (26) d'interruption, le contrôleur (12) de test interrompt un programme de test en cours et fait débuter un test de rétention ou de bump et après l'arrivée d'un deuxième signal (26) d'interruption, poursuit le programme de test interrompu.
